# EUROPEAN PATENT SPECIFICATION

(11) **EP 3 862 403 B1**
(45) Date of publication and mention of the grant of the patent: **27.08.2025**
(21) Application number: 19869448.1
(22) Date of filing: 20.09.2019
(51) Int. Cl.: C09J 7/38, C09J 5/00, C09J 7/25, C09J 11/00, C09J 133/00, C09J 201/00, H01L 21/56, H01L 21/683, H01L 23/00, B32B 27/00, B32B 7/06, B32B 7/12, B32B 25/00, B32B 5/20

(54) **USE OF AN ADHESIVE FILM FOR TEMPORARILY FIXING AN ELECTRONIC COMPONENT**
VERWENDUNG EINES KLEBEFILMS ZUR TEMPORÄREN FIXIERUNG EINES ELEKTRONISCHEN BAUTEILS
UTILISATION D'UN FILM ADHÉSIF POUR LA FIXATION TEMPORAIRE D'UN DISPOSITIF ÉLECTRONIQUE

(30) Priority: 05.10.2018 JP 2018190041
(43) Date of publication of application: 11.08.2021
(73) Proprietor: Mitsui Chemicals ICT Materia, Inc., Tokyo 104-0028 (JP)
(72) Inventor: MIURA, Toru, Tokyo 1040028 (JP); IGARASHI, Kouji, 40211 Duesseldorf (DE); KURIHARA, Hiroyoshi, Nagoya-shi, Aichi 457-0801 (JP)
(74) Representative: Hoffmann Eitle
(86) International application number: PCT/JP2019/036993
(87) International publication number: WO 2020/071159

(56) References cited:
- WO-A1-2014/192631
- WO-A1-2015/029871
- WO-A1-2017/170452
- WO-A1-2018/135546
- JP-A- 2009 132 867
- JP-A- 2011 134 811
- JP-A- 2012 031 315
- JP-A- 2012 062 373
- JP-A- 2012 062 373
- JP-A- 2018 157 037
- US-A1- 2013 342 925
- US-A1- 2014 087 180

## Description

### TECHNICAL FIELD

The present invention relates to the use of an adhesive film for temporarily fixing an electronic component when the electronic component is sealed with a sealing material in an electronic device manufacturing process and a method for manufacturing an electronic device.

### BACKGROUND ART

As a technology which is able to reduce the size and weight of electronic devices (for example, semiconductor apparatuses), a fan-out type WLP (wafer level package) is being developed.

In an eWLB (Embedded Wafer Level Ball Grid Array), which is one of the methods for manufacturing a fan-out type WLP, it is possible to adopt a method in which a plurality of electronic components such as semiconductor chips are temporarily fixed in a separated state on an adhesive film attached to a support substrate, and the plurality of electronic components are sealed in a batch with a sealing material. Here, the adhesive film needs to be fixed to the electronic component and the support substrate in the sealing step and needs to be removed from the sealed electronic component and the support substrate after the sealing.

Examples of a technique related to such a fan-out type WLP manufacturing method include the technique described in Patent Document 1 (Japanese Patent Laid-Open No. 2011-134811).

Patent Document 1 discloses a heat-resistant adhesive sheet for manufacturing a semiconductor apparatus, which is used by being attached when resin-sealing a substrateless semiconductor chip, in which the heat resistant adhesive sheet has a base material layer and an adhesive layer, the adhesive layer has an adhesive force to SUS304 after bonding of 0.5 N/20 mm or more, is cured by a stimulus received until the completion of a resin sealing step, and has a peel force with respect to a package of 2.0 N/20 mm or less.
JP 2012 062373 describes a method for manufacturing a substrateless semiconductor package using a pressure-sensitive adhesive tape as a temporary fixing support. The heat-resistant pressure-sensitive adhesive tape for manufacturing the semiconductor device is a pressure-sensitive adhesive tape for temporarily fixing a chip, which is stuck to the chip and used in resin sealing the substrateless semiconductor chip, and has pressure-sensitive adhesive layers on both surfaces holding a substrate layer in between, wherein a silicone pressure-sensitive adhesive is contained in at least one of the pressure-sensitive adhesive layers on the side of resin sealing of the semiconductor chip.
JP 2009 132867 A describes a double-sided adhesive sheet for processing a plate member that includes a base material, a first adhesive layer being laminated on one surface of the base material and being adhered to a rigid support plate, and a second adhesive layer which is laminated on the other side of the base material and being adhered to a semiconductor wafer. The first adhesive layer contains a silicone compound having percent weight loss by thermogravimetry (TG) of ≤20% at 150°C.
JP 2012 031315 A describes a heat-resistant temporary adhesion adhesive tape having high initial adhesion force relative to a polyimide resin surface, hardly reducing adhesion force even if it is exposed to high temperature, having adhesion force required for fixation and protection and capable of being easily peeled off without remaining paste when it is peeled off and removed. In the heat-resistant temporary adhesion adhesive tape, an adhesive layer comprising a material for forming the adhesive layer containing an acrylic polymer, an energy ray polymerizable oligomer, a polymerization initiator and a vulcanizing agent is formed on a heat-resistant substrate, and the mass ratio of a hydroxyl group-containing monomer and a carboxyl group-containing monomer in the acrylic polymer is 51:49-100:0. In the polymerization initiator, the weight loss rate by thermogravimetric measurement is 50% or less when the temperature is increased from 30 ° C to 190 ° C at a temperature of 10 ° C / min and maintained at 190 ° C for 30 minutes.

### RELATED DOCUMENT

### PATENT DOCUMENT

[Patent Document 1] Japanese Patent Laid-Open No. 2011-134811

### SUMMARY OF THE INVENTION

### TECHNICAL PROBLEM

According to studies by the inventors of the present invention, the inventors found that, when an electronic component is arranged on an adhesive film and the electronic component is sealed with a sealing material, the position of the electronic component may be shifted (also referred to below as position shifting of electronic components).

The present invention was made in view of the above circumstances and provides an adhesive film capable of suppressing position shifting of electronic components in a sealing step.

### SOLUTION TO PROBLEM

The inventors of the present invention carried out intensive studies in order to achieve the above object. As a result, it was found that, in an adhesive film provided with a base material layer, an adhesive resin layer (A) which is provided on a first surface side of the base material layer, and an adhesive resin layer (B) which is provided on a second surface side of the base material layer and of which an adhesive force is decreased by an external stimulus, measuring a shrinkage rate of the adhesive film, which is measured by a specific method, is effective as a design guideline for an adhesive film for suppressing position shifting of electronic components in a sealing step, thereby completing the present invention.

According to the present invention, the use of an adhesive film for temporarily fixing an electronic component when the electronic component is sealed with a sealing material in an electronic device manufacturing process and a method for manufacturing an electronic device illustrated below are provided.

[1] Use of an adhesive film for temporarily fixing an electronic component when the electronic component is sealed with a sealing material in an electronic device manufacturing process,
   the adhesive film including a base material layer, an adhesive resin layer (A) which is provided on a first surface side of the base material layer, and an adhesive resin layer (B) which is provided on a second surface side of the base material layer and of which an adhesive force is decreased by heating or radiation as an external stimulus, in which a shrinkage rate of the film in a direction that the heat shrinkage of the adhesive film is maximum is 0.0% or more and 0.40% or less as measured under conditions of heating at 150°C for 30 minutes in accordance with JIS C2151,
   the base material layer includes a uniaxially stretched or biaxially stretched polyester film and
   the adhesive resin layer (A) includes a (meth)acrylic adhesive resin.
[2] A method for manufacturing an electronic device including at least a step (1) of preparing a structure having the adhesive film as defined above, an electronic component attached to the adhesive resin layer (A) of the adhesive film, and a support substrate attached to the adhesive resin layer (B) of the adhesive film; a step (2) of sealing the electronic component with a sealing material; a step (3) of peeling the support substrate from the structure by decreasing an adhesive force of the adhesive resin layer (B) by applying an external stimulus; and a step (4) of peeling the adhesive film from the electronic component.

### ADVANTAGEOUS EFFECTS OF INVENTION

According to the present invention, it is possible to use an adhesive film for temporarily fixing an electronic component when the electronic component is sealed with a sealing material in an electronic device manufacturing process while suppressing position shifting of the electronic component in the sealing step.

### BRIEF DESCRIPTION OF THE DRAWINGS

Fig. 1 is a cross-sectional view schematically showing an example of a structure of an adhesive film for use according to an embodiment according to the present invention.
Fig. 2 is a cross-sectional view schematically showing an example of a method for manufacturing an electronic device of an embodiment according to the present invention.
Fig. 3 is a cross-sectional view schematically showing an example of a method for manufacturing an electronic device of an embodiment according to the present invention.

### DESCRIPTION OF EMBODIMENTS

A description will be given below of embodiments of the present invention with reference to the drawings. In all the drawings, common reference numerals are given to the same constituent components and description thereof will be appropriately omitted. In addition, the figures are schematic views and do not match the actual dimensional ratios. In addition, unless otherwise specified, **"A to B"** in the numerical range represents A or more and B or less. In addition, in the present embodiment, "(meth)acrylic" means acrylic, methacrylic, or both acrylic and methacrylic.

### 1. Adhesive Film

A description will be given below of an adhesive film 50 according to the present embodiment.

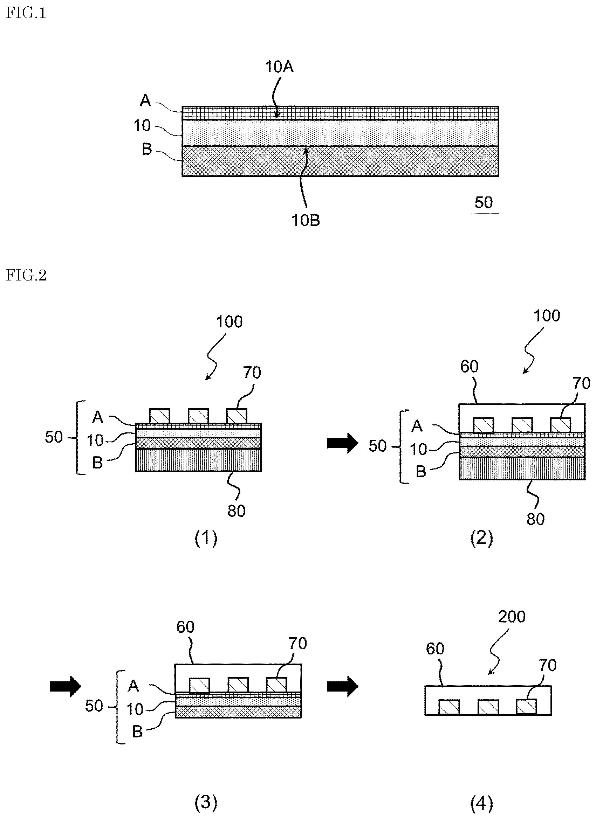

Fig. 1 is a cross-sectional view schematically showing an example of the structure of the adhesive film 50 for use according to the embodiment according to the present invention.

As shown in Fig. 1, the adhesive film 50 according to the present embodiment is provided with a base material layer 10, an adhesive resin layer (A) which is provided on a first surface 10A side of the base material layer 10, and an adhesive resin layer (B) which is provided on a second surface 10B side of the base material layer 10 and of which an adhesive force is decreased by an external stimulus, in which a shrinkage rate of the film in a direction that the heat shrinkage is maximum is 0.0% or more and 0.40% or less as measured under conditions of heating at 150°C for 30 minutes in accordance with JIS C2151.

Here, in an MD direction of the resin film for forming the base material layer 10, winding stress is applied during film formation, such that the stress remains after film formation and there is a tendency for the shrinkage to increase, thus, a direction that a heat shrinkage of the adhesive film 50 is the largest is often the MD direction of the resin film for forming the base material layer 10.

In addition, in a case where the resin film for forming the base material layer 10 is a uniaxially stretched film or a biaxially stretched film, a direction that a heat shrinkage of the adhesive film 50 is the largest is often a direction that the stretch ratio is the largest.

As described above, according to studies by the inventors of the present invention, it is clear that, when an electronic component is arranged on an adhesive film and the electronic component is sealed with a sealing material, the position of the electronic component may be shifted.

The inventors of the present invention carried out extensive studies in order to realize an adhesive film which is able to suppress position shifting of electronic components in the sealing step. As a result, it was found for the first time that, in the adhesive film 50 provided with the base material layer 10, the adhesive resin layer (A) which is provided on the first surface 10A side of the base material layer 10, and the adhesive resin layer (B) which is provided on the second surface 10B side of the base material layer 10 and of which an adhesive force is decreased by an external stimulus, measuring the shrinkage rate of the film in a direction that the heat shrinkage is maximum under conditions of heating at 150°C for 30 minutes in accordance with JIS C2151 is effective as a design guideline for an adhesive film for suppressing position shifting of electronic components in a sealing step.

That is, forming the adhesive film 50 according to the present embodiment such that the shrinkage rate of the film in a direction that the heat shrinkage is maximum is 0.0% or more and 0.40% or less as measured under conditions of heating at 150°C for 30 minutes in accordance with JIS C2151 makes it possible to suppress position shifting of electronic components in the sealing step.

It is not clear why the use of the adhesive film 50 according to the present embodiment makes it possible to suppress position shifting of electronic components in the sealing step, but the following reasons may be considered.

First, in the manufacturing process of an electronic device such as eWLB, after temporarily fixing a plurality of electronic components on an adhesive film in a separated state, a preheating step called prebaking is usually performed before a step of sealing the electronic components with a sealing material.

According to studies by the present inventors, among the adhesive films attached to the support substrate during this prebaking step, floating mainly occurs on the outer peripheral surface and the floating of the adhesive film causes floating to be generated between the adhesive film and the support substrate during the sealing step and, as a result, the sealing material penetrates between the adhesive film and the electronic component.

That is, it is considered that the sealing material penetrates between the adhesive film and the electronic component and, as a result, the position of the electronic component shifts in the sealing step.

Furthermore, according to studies by the present inventors, it was found that heat shrinkage of the adhesive film may occur during the prebaking step and the sealing step.

That is, it is considered that the heat shrinkage of the adhesive film in the prebaking step and the sealing step causes the position of the electronic component temporarily fixed on the adhesive film to shift.

On the other hand, it is considered that the adhesive film 50 having a shrinkage rate of 0.0% or more and 0.40% or less in the direction of maximum heat shrinkage is less likely to float from the support substrate in the prebaking step or the sealing step and gaps do not easily occur between the adhesive film and the support substrate, thus, it is difficult for the sealing material to penetrate and, as a result, it is possible to suppress position shifting of electronic components in the sealing step.

Furthermore, it is considered that the adhesive film 50 having a shrinkage rate of 0.0% or more and 0.40% or less in the direction of maximum heat shrinkage is less likely to cause heat shrinkage in the prebaking step and the sealing step and, as a result, it is possible to suppress position shifting of electronic components in the sealing step.

For the above reasons, it is considered that the use of the adhesive film 50 according to the present embodiment makes it possible to suppress position shifting of electronic components in the sealing step.

In the adhesive film 50 according to the present embodiment, the upper limit of the shrinkage rate of the film in a direction that the heat shrinkage is maximum is 0.40% or less as measured under conditions of heating at 150°C for 30 minutes and, from the viewpoint of making it possible to further suppress position shifting of electronic components in the sealing step, 0.30% or less is preferable, 0.20% or less is more preferable, 0.10% or less is even more preferable, and 0.05% or less is particularly preferable.

In the adhesive film 50 according to the present embodiment, it is possible to control the shrinkage rate of the film in a direction that the heat shrinkage is maximum as measured under conditions of heating at 150°C for 30 minutes in accordance with JIS C2151, by, for example, using a film having a low heat shrinkage rate as the resin film for forming the base material layer 10; performing a stress relaxation treatment such as a heat treatment on the resin film for forming the base material layer 10 to reduce the thermal stress; setting the drying temperature at the time of forming the adhesive resin layer (A) and the adhesive resin layer (B) on the base material layer 10 to a higher temperature, and reducing the thermal stress of the adhesive resin layer (A), the adhesive resin layer (B), and the base material layer 10.

From the viewpoint of the balance between mechanical properties and handleability, the total thickness of the adhesive film 50 according to the present embodiment is preferably 10 µm or more and 1000 µm or less, and more preferably 20 µm or more and 500 µm or less.

It is possible to use the adhesive film 50 according to the present embodiment, for example, in a film for temporarily fixing electronic components when sealing the electronic component with a sealing material in an electronic device manufacturing process, and particularly, suitable use is possible as a film for temporarily fixing electronic components in a manufacturing process for a fan-out type WLP or a fan-out type PLP.

Next, a description will be given of each layer forming the adhesive film 50 according to the present embodiment.

### <Base Material Layer>

The base material layer 10 is a layer provided for the purpose of improving properties such as the handleability, mechanical properties, and heat resistance of the adhesive film 50.

The base material layer 10 is not particularly limited and examples thereof include a resin film.

It is possible to use a known thermoplastic resin as the resin forming the resin film. Examples thereof include one type or two or more types selected from polyolefins such as polyethylene, polypropylene, poly(4-methyl-1-pentene), and poly(1-butene); polyesters such as polyethylene terephthalate, polybutylene terephthalate, and polyethylene naphthalate; polyamides such as nylon-6, nylon-66, and polymethaxylene adipamide; polyacrylates; polymethacrylates; polyvinyl chloride; polyvinylidene chloride; polyimides; polyetherimides; ethylene/vinyl acetate copolymers; polyacrylonitrile; polycarbonates; polystyrenes; ionomers; polysulfones; polyethersulfones; and polyphenylene ether. Among the above, from the viewpoint of excellent balance of low shrinkage, mechanical strength, and price, polyesters such as polyethylene terephthalate, polybutylene terephthalate, and polyethylene naphthalate are preferable, and polyethylene terephthalate and polybutylene terephthalate are more preferable.

The base material layer 10 may be a single layer or two or more types of layers.

In addition, from the viewpoint of excellent balance of low shrinkage and mechanical strength of the base material layer 10, the form of the resin film used for forming the base material layer 10 is a film stretched in a uniaxial direction or biaxial directions.

As the resin film used for forming the base material layer 10, from the viewpoint of excellent balance of low shrinkage, mechanical strength, and price, a uniaxially stretched or biaxially stretched polyester film is used, and a uniaxially stretched or biaxially stretched polyethylene terephthalate (PET) film is particularly preferable.

The shrinkage rate in the direction of maximum heat shrinkage of the base material layer 10 as measured under conditions of heating at 150°C for 30 minutes in accordance with JIS C2151 is preferably 0.0% or more and 1.3% or less, and more preferably 0.0% or more and 1.3% or less. When the shrinkage rate of the base material layer 10 in the direction of maximum heat shrinkage is within the above range, it is easy to control the shrinkage rate of the adhesive film 50 in the direction of maximum heat shrinkage within the above range, which is preferable.

Here, in the MD direction of the resin film for forming the base material layer 10, the winding stress is applied during the film formation, such that the stress remains after the film formation and the shrinkage tends to increase, thus, the direction of maximum heat shrinkage of the base material layer 10 is often the MD direction of the resin film for forming the base material layer 10.

In addition, in a case where the resin film for forming the base material layer 10 is a uniaxially stretched film or a biaxially stretched film, the direction of maximum heat shrinkage of the base material layer 10 is often the direction that the stretch ratio is the largest.

Here, it is possible to control the shrinkage rate in the direction of maximum heat shrinkage of the base material layer 10 by, for example, performing a stress relaxation treatment such as a heat treatment on the resin film used for forming the base material layer 10 and reducing thermal stress.

In a case where the resin film used to form the base material layer 10 is a uniaxially stretched or biaxially stretched polyethylene terephthalate (PET) film, the heat treatment temperature is, for example, 140°C or higher and 240°C or lower and the heat treatment time is, for example, 10 seconds or more and 200 seconds or less.

From the viewpoint of obtaining good film properties, the thickness of the base material layer 10 is preferably 1 µm or more and 500 µm or less, more preferably 5 µm or more and 300 µm or less, and even more preferably 10 µm or more and 250 µm or less.

The base material layer 10 may be surface-treated in order to improve the adhesion with other layers. Specifically, a corona treatment, a plasma treatment, an undercoat treatment, or a primer coat treatment may be performed.

### <Adhesive Resin Layer (A)>

The adhesive resin layer (A) is a layer provided on one surface side of the base material layer 10, and, for example, is a layer for contacting the surface of the electronic component to temporarily fix the electronic component when the electronic component is sealed with a sealing material in the electronic device manufacturing process.

The adhesive resin layer (A) includes an adhesive resin (A1).

Examples of the adhesive resin (A1) include a (meth)acrylic adhesive resin (a), a silicone-based adhesive resin, a urethane-based adhesive resin, an olefin-based adhesive resin, and a styrene-based adhesive resin.

Among the above, the (meth)acrylic adhesive resin (a) is used from the viewpoint of facilitating the adjustment of the adhesive force.

As the adhesive resin layer (A), it is also possible to use a radiation-cross-linking adhesive resin layer that the adhesive force is decreased by radiation. The radiation cross-linking adhesive resin layer is cross-linked by the irradiation of radiation and the adhesive force is significantly reduced, thus, the adhesive film 50 is easily peeled from the electronic component. Examples of the radiation include ultraviolet rays, electron beams, and infrared rays.

As the radiation cross-linking adhesive resin layer, an ultraviolet cross-linking adhesive resin layer is preferable.

Examples of the (meth)acrylic adhesive resin (a) used in the adhesive resin layer (A) include a copolymer including a (meth) acrylic acid alkyl ester monomer unit (a1) and a monomer unit (a2) having a functional group capable of reacting with a cross-linking agent.

In the present embodiment, the (meth) acrylic acid alkyl ester means an acrylic acid alkyl ester, a methacrylic acid alkyl ester, or a mixture thereof.

It is possible to obtain the (meth)acrylic adhesive resin (a) according to the present embodiment, for example, by copolymerizing a monomer mixture including the (meth)acrylic acid alkyl ester monomer (a1) and the monomer (a2) having a functional group capable of reacting with a cross-linking agent.

Examples of the monomer (a1) forming the (meth)acrylic acid alkyl ester monomer unit (a1) include a (meth) acrylic acid alkyl ester having an alkyl group having approximately 1 to 12 carbon atoms. A (meth) acrylic acid alkyl ester having an alkyl group having 1 to 8 carbon atoms is preferable. Specific examples thereof include methyl acrylate, methyl methacrylate, ethyl acrylate, ethyl methacrylate, butyl acrylate, butyl methacrylate, 2-ethylhexyl acrylate, and 2-ethylhexyl methacrylate. These may be used alone or in a combination of two or more types.

In the (meth) acrylic adhesive resin (a) according to the present embodiment, when the total of all the monomer units in the (meth) acrylic adhesive resin (a) is 100% by mass, the content of the (meth) acrylic acid alkyl ester monomer unit (a1) is preferably 10% by mass or more and 98.9% by mass or less, more preferably 50% by mass or more and 97% by mass or less, and even more preferably 85% by mass or more and 95% by mass or less.

Examples of the monomer (a2) forming the monomer (a2) having a functional group capable of reacting with the cross-linking agent include acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, 2-hydroxyethyl acrylate, 2-hydroxyethyl meth acrylate, acrylamide, methacrylamide, tert-butylaminoethyl acrylate, and tert-butylaminoethyl methacrylate. Preferable are acrylic acid, methacrylic acid, 2-hydroxyethyl acrylate, 2-hydroxyethyl meth acrylate, acrylamide, and methacrylamide. These may be used alone or in a combination of two or more types.

In the (meth) acrylic adhesive resin (a) according to the present embodiment, when the total of all the monomer units in the (meth) acrylic adhesive resin (a) is 100% by mass, the content of the monomer unit (a2) is preferably 1% by mass or more and 40% by mass or less, more preferably 1% by mass or more and 20% by mass or less, and even more preferably 1% by mass or more and 10% by mass or less.

The (meth) acrylic adhesive resin (a) according to the present embodiment may, in addition to the monomer unit (a1) and the monomer unit (a2), further include a bifunctional monomer unit (a3) and a specific comonomer (referred to below as a polymerizable surfactant) unit having properties as a surfactant.

The polymerizable surfactant has a property of copolymerizing with the monomer (a1), the monomer (a2), and the monomer (a3), and also has an action as an emulsifier in the case of emulsion polymerization.

Examples of the monomer (a3) forming the bifunctional monomer unit (a3) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di(meth)acrylate, or, for example, monomers in which a main chain structure is a propylene glycol type with diacrylate or dimethacrylate at both ends (for example, manufactured by NOF Corp., trade name: PDP-200, PDP-400, ADP-200, and ADP-400), tetramethylene glycol type monomers (for example, manufactured by NOF Corp.; trade name: ADT-250, ADT-850), and mixtures thereof (for example, manufactured by NOF Corp., trade name: ADET-1800 and ADPT-4000).

In the (meth) acrylic adhesive resin (a) according to the present embodiment, when the total of all the monomer units in the (meth) acrylic adhesive resin (a) is 100% by mass, the content of the monomer unit (a3) is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

Examples of the polymerizable surfactant include a surfactant in which a polymerizable 1-propenyl group is introduced into a benzene ring of polyoxyethylene nonylphenyl ether (manufactured by Daiichi Kogyo Seiyaku Co., Ltd.; trade name: Aqualon RN-10, RN-20, RN-30, and RN-50), a surfactant in which a polymerizable 1-propenyl group is introduced into a benzene ring of ammonium salt of sulfuric acid ester of polyoxyethylene nonylphenyl ether (manufactured by Daiichi Kogyo Seiyaku Co., Ltd.; trade name: Aqualon HS-10, HS-20, and HS-1025), and a sulfosuccinate diester-based surfactant having a polymerizable double bond in the molecule (manufactured by Kao Corp.; trade name: Latemul S-120A and S-180A).

In the (meth) acrylic adhesive resin (a) according to the present embodiment, when the total of all the monomer units in the (meth) acrylic adhesive resin (a) is 100% by mass, the content of the polymerizable surfactant is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

The (meth)acrylic adhesive resin (a) according to the present embodiment may further include a monomer unit formed of a monomer having a polymerizable double bond such as vinyl acetate, acrylonitrile, or styrene, as necessary.

Examples of the polymerization reaction mechanism of the (meth) acrylic adhesive resin (a) according to the present embodiment include radical polymerization, anionic polymerization, and cationic polymerization. In consideration of the manufacturing cost of the (meth) acrylic adhesive resin (a), the influence of the functional group of the monomer, and the influence of ions on the surface of the electronic component, it is preferable to carry out the polymerization by radical polymerization.

When polymerizing by a radical polymerization reaction, examples of radical polymerization initiators include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butylperoxyphthalate, t-butylperoxybenzoate, di-t-butylperoxyacetate, t-butylperoxyisobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide, and di-t-amyl peroxide; inorganic peroxides such as ammonium persulfate, potassium persulfate, and sodium persulfate; azo compounds such as 2,2'-azobisisobutyronitrile, 2,2'-azobis-2-methylbutyronitrile, and 4,4'-azobis-4-cyanovaleric acid.

In a case of polymerizing by an emulsion polymerization method, among these radical polymerization initiators, inorganic peroxides such as water-soluble ammonium persulfate, potassium persulfate, and sodium persulfate, and azo compounds having a carboxyl group in the molecule such as water-soluble 4,4'-azobis-4-cyanovaleric acid are preferable. Considering the influence of ions on the surface of the electronic components, ammonium persulfate and azo compounds having a carboxyl group in the molecule such as 4,4'-azobis-4-cyanovaleric acid are more preferable, and azo compounds having a carboxyl group in the molecule such as 4,4'-azobis-4-cyanovaleric acid are particularly preferable.

The adhesive resin layer (A) according to the present embodiment preferably further includes a cross-linking agent (A2) having two or more cross-linkable functional groups in one molecule, in addition to the adhesive resin (A1).

A cross-linking agent (A2) having two or more cross-linkable functional groups in one molecule is used to react with the functional group of the adhesive resin (A1) and adjust the adhesive force and aggregating force.

Examples of such a cross-linking agent (A2) include epoxy-based compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcin diglycidyl ether; isocyanate-based compounds such as tetramethylene diisocyanate, hexamethylene diisocyanate, toluene diisocyanate 3 adducts of trimethylolpropane, polyisocyanate, diphenylmethane diisocyanate, and tolylene diisocyanate; aziridine-based compounds such as trimethylolpropane-tri-β-aziridinylpropionate, tetramethylolmethane-tri-β-aziridinylpropionate, N,N'-diphenylmethane-4,4'-bis(1-aziridinecarboxamide), N,N'-hexamethylene-1,6-bis(1-aziridinecarboxamide), N,N'-toluene-2,4-bis(1-aziridinecarboxamide), and trimethylolpropane-tri-β-(2-methylaziridine) propionate; tetrafunctional epoxy-based compounds such as N,N,N',N'-tetraglycidyl-m-xylenediamine and 1,3-bis(N,N'-diglycidylaminomethyl) cyclohexane; and melamine-based compounds such as hexamethoxymethylolmelamine. These may be used alone or in a combination of two or more types.

Among the above, it is preferable to include one type or two or more types selected from an epoxy-based compound, an isocyanate-based compound, and an aziridine-based compound.

The content of the cross-linking agent (A2) is usually preferably in a range that the number of functional groups in the cross-linking agent (A2) does not exceed the number of functional groups in the adhesive resin (A1). However, in a case where a functional group is newly generated in the cross-linking reaction, or a case where the cross-linking reaction is slow, the content thereof may be greater as necessary.

From the viewpoint of improving the balance between the heat resistance and the adhesive force of the adhesive resin layer (A), the content of the cross-linking agent (A2) in the adhesive resin layer (A) is preferably 0.1 parts by mass or more and 15 parts by mass or less with respect to 100 parts by mass of the adhesive resin (A1).

When the entire adhesive resin layer (A) is 100% by mass, the total content of the adhesive resin (A1) and the cross-linking agent (A2) in the adhesive resin layer (A) is preferably 50% by mass or more and 100% by mass or less, more preferably 70% by mass or more and 100% by mass or less, even more preferably 90% by mass or more and 100% by mass or less, and particularly preferably 95% by mass or more and 100% by mass or less. Due to this, it is possible to further suppress adhesive residue on the electronic component side when the adhesive film is peeled off from the electronic component.

The thickness of the adhesive resin layer (A) is not particularly limited, but is, for example, preferably 1 µm or more and 100 µm or less, and more preferably 3 µm or more and 50 µm or less.

It is possible to form the adhesive resin layer (A), for example, by coating an adhesive on the base material layer 10. The adhesive may be dissolved in a solvent and coated as a coating solution, coated as an aqueous emulsion, or directly coated as a liquid adhesive.

Among the above, an aqueous emulsion coating solution is preferable. Examples of the aqueous emulsion coating solution include coating solutions in which the (meth) acrylic adhesive resin (a), a silicone-based adhesive resin, a urethane-based adhesive resin, an olefin-based adhesive resin, or a styrene-based adhesive resin is dispersed in water.

An adhesive coating solution dissolved in an organic solvent may be used. The organic solvent is not particularly limited and may be appropriately selected from known organic solvents in consideration of solubility and drying time. Examples of organic solvents include ester-based organic solvents such as ethyl acetate and methyl acetate; ketone-based organic solvents such as acetone and MEK; aromatic-based organic solvents such as benzene, toluene, and ethylbenzene; linear or cyclic aliphatic-based organic solvents such as heptane, hexane, and cyclohexane; alcohol-based organic solvents such as isopropanol and butanol. Ethyl acetate and toluene are preferable as the organic solvent. These solvents may be used alone as one type or used in a mixture of two or more types. As a method for coating the adhesive coating solution, it is possible to adopt a coating method known in the related art, for example, a roll coater method, a reverse roll coater method, a gravure roll method, a bar coating method, a comma coater method, or a die coater method. From the viewpoint of reducing the thermal stress of the adhesive resin layer (A) and the base material layer 10 and reducing the shrinkage rate of the adhesive film 50, the drying conditions of the coated adhesive are preferably drying for 10 seconds to 5 minutes in the temperature range of 100 to 240°C.

More preferably, drying is performed in a temperature range of 120 to 200°C for 30 seconds to 3 minutes.

### <Adhesive Resin Layer (B)>

The adhesive film 50 according to the present embodiment is provided with an adhesive resin layer (B) on the second surface 10B side of the base material layer 10 on the opposite side to the first surface 10A, the adhesive force of which is decreased by heating or radiation as an external stimulus.

Due to this, it is possible to easily peel the adhesive film 50 from the support substrate 80 by applying an external stimulus.

Here, examples of the adhesive resin layer (B), the adhesive force of which is decreased by heating or radiation as an external stimulus, include a heat-peelable adhesive resin layer, the adhesive force of which is decreased by heating, and a radiation-peelable adhesive resin layer, the adhesive force of which is decreased by radiation.

Among the above, a heat-peelable adhesive resin layer, the adhesive force of which is decreased by heating, is preferable.

Examples of the heat-peelable adhesive resin layer include adhesive resin layers formed of a heat-expandable adhesive including a gas generating component, a heat-expandable adhesive including heat-expandable microspheres capable of expanding to decrease the adhesive force, a heat-expandable adhesive, the adhesive force of which is decreased by the cross-linking reaction of the adhesive components due to heat.

In the present embodiment, the heat-expandable adhesive used in the adhesive resin layer (B) is an adhesive, the adhesive force of which is decreased or lost by heating at a temperature over 180°C, for example. For example, it is possible to select a material which does not peel at a temperature of 180°C or lower and which does peel at a temperature over 180°C and the heat-expandable adhesive preferably has an adhesive force such that the adhesive film 50 does not peel from the support substrate 80 during the electronic device manufacturing process.

Here, it is possible to evaluate whether the adhesive force is decreased or lost by heating at a temperature over 180°C, for example, by attaching the adhesive resin layer (B) side to a stainless steel sheet, performing a heat treatment at 140°C for 1 hour, then heating for 2 minutes at a temperature over 180°C and measuring the peel force from the stainless steel sheet. The specific heating temperature when heating at a temperature over 180°C is set to a temperature higher than the temperature at which the gas is generated or the temperature at which the heat-expandable microspheres are heat-expanded and is appropriately set depending on the gas to be generated or the type of heat-expandable microspheres. In the present embodiment, the loss of adhesive force means, for example, a case where the 180° peel force measured under the conditions of 23°C and a tensile speed of 300 mm/min becomes less than 0.5 N/25 mm.

As the gas generating component used in the heat-expandable adhesive, for example, it is possible to use an azo compound, an azide compound, or a Meldrum's acid derivative. In addition, it is also possible to use inorganic foaming agents such as ammonium carbonate, ammonium hydrogencarbonate, sodium hydrogencarbonate, ammonium nitrite, sodium borohydride, and various azides, or water; salts of fluoroalkane-based compounds such as trichloromonofluoromethane and dichloromonofluoromethane; azo-based compounds such as azobisisobutyronitrile, azodicarbonamide, and barium azodicarboxylate; hydrazine-based compounds such as paratoluenesulfonyl hydrazide, diphenylsulfone-3,3'-disulfonylhydrazide, 4,4'-oxybis(benzenesulfonyl hydrazide) and allylbis(sulfonylhydrazide); semicarbazide-based compounds such as p-toluylenesulfonyl semicarbazide, and 4,4'-oxybis(benzenesulfonyl semicarbazide); triazole-based compounds such as 5-morpholyl-1,2,3,4-thiatriazole; organic foaming agents such as N-nitroso compounds such as N,N'-dinitrosopentamethylenetetramine, and N,N'-dimethyl-N,N'-dinitrosoterephthalamide. The gas generating component may be added to the adhesive resin (B1) or may be directly bonded to the adhesive resin (B1).

As the heat-expandable microspheres used for the heat-expandable adhesive, for example, it is possible to use a microencapsulated foaming agent. Examples of such heat-expandable microspheres include microspheres in which a substance that is easily gasified and expanded by heating such as isobutane, propane, and pentane is sealed in a shell having elasticity. Examples of the material forming the shell include vinylidene chloride-acrylonitrile copolymer, polyvinyl alcohol, polyvinyl butyral, polymethyl methacrylate, polyacrylonitrile, polyvinylidene chloride, and polysulfone. It is possible to manufacture heat-expandable microspheres by, for example, a coacervation method, or an interfacial polymerization method.

It is possible to add heat-expandable microspheres to the adhesive resin.

It is possible to appropriately set the content of at least one type selected from the gas generating component and the heat-expandable microspheres according to the expansion ratio and the decrease in adhesive force of the heat-peelable adhesive resin layer (B) without being particularly limited; however, for example, with respect to 100 parts by mass of the adhesive resin (B1) in the heat-peelable adhesive resin layer (B), the content is, for instance, 1 part by mass or more and 150 parts by mass or less, preferably 10 parts by mass or more and 130 parts by mass or less, and more preferably 12 parts by mass or more and 100 parts by mass or less.

It is preferable to implement the design such that the temperature at which gas is generated or the temperature at which the heat-expandable microspheres heat-expand is over 180°C.

Examples of the adhesive resin (B1) forming the heat-expandable adhesive include a (meth) acrylic resin (b), a urethane-based resin, a silicone-based resin, a polyolefin-based resin, a polyester-based resin, a polyamide-based resin, a fluorine resin-based resin, and a styrene-diene block copolymer-based resin. Among these, the (meth)acrylic resin (b) is preferable.

Examples of the (meth)acrylic adhesive resin (b) used in the adhesive resin layer (B) include a copolymer including the (meth) acrylic acid alkyl ester monomer unit (b1) and the monomer unit (b2) having a functional group capable of reacting with a cross-linking agent.

In the present embodiment, (meth) acrylic acid alkyl ester means acrylic acid alkyl ester, methacrylic acid alkyl ester, or a mixture thereof.

It is possible to obtain the (meth) acrylic adhesive resin (b) according to the present embodiment, for example, by copolymerizing a monomer mixture including a (meth) acrylic acid alkyl ester monomer (b1) and a monomer (b2) having a functional group capable of reacting with a cross-linking agent.

Examples of the monomer (b1) forming the (meth)acrylic acid alkyl ester monomer unit (b1) include a (meth) acrylic acid alkyl ester having an alkyl group having approximately 1 to 12 carbon atoms. A (meth) acrylic acid alkyl ester having an alkyl group having 1 to 8 carbon atoms is preferable. Specific examples thereof include methyl acrylate, methyl methacrylate, ethyl acrylate, ethyl methacrylate, butyl acrylate, butyl methacrylate, 2-ethylhexyl acrylate, and 2-ethylhexyl methacrylate. These may be used alone or in a combination of two or more types.

In the (meth) acrylic adhesive resin (b) according to the present embodiment, when the total of all the monomer units in the (meth) acrylic adhesive resin (b) is 100% by mass, the content of the (meth) acrylic acid alkyl ester monomer unit (b1) is preferably 10% by mass or more and 98.9% by mass or less, more preferably 50% by mass or more and 97% by mass or less, and even more preferably 85% by mass or more and 95% by mass or less.

Examples of the monomer (b2) forming the monomer (b2) having a functional group capable of reacting with the cross-linking agent include acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, 2-hydroxyethyl acrylate, 2-hydroxyethyl methacrylic acid, acrylamide, methacrylamide, tert-butylaminoethyl acrylate, and tert-butylaminoethyl methacrylate.

Preferable examples are acrylic acid, methacrylic acid, 2-hydroxyethyl acrylate, 2-hydroxyethyl methacrylic acid, acrylamide, and methacrylamide.

These may be used alone or in a combination of two or more types.

In the (meth) acrylic adhesive resin (b) according to the present embodiment, when the total of all the monomer units in the (meth) acrylic adhesive resin (b) is 100% by mass, the content of the monomer unit (b2) is preferably 1% by mass or more and 40% by mass or less, more preferably 1% by mass or more and 20% by mass or less, and even more preferably 1% by mass or more and 10% by mass or less.

The (meth)acrylic adhesive resin (b) according to the present embodiment may further include a bifunctional monomer unit (b3) and a specific comonomer (referred to below as a polymerizable surfactant) unit having a property as a surfactant in addition to the monomer unit (b1) or the monomer unit (b2).

The polymerizable surfactant has a property of copolymerizing with the monomer (b1), the monomer (b2), and a monomer (b3), and has an action as an emulsifier in a case of emulsion polymerization.

Examples of the monomer (b3) forming the bifunctional monomer unit (b3) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di(meth)acrylate, or, for example, monomers in which a main chain structure is a propylene glycol type with diacrylate or dimethacrylate at both ends (for example, manufactured by NOF Corp., trade name: PDP-200, PDP-400, ADP-200, and ADP-400), tetramethylene glycol type monomers (for example, manufactured by NOF Corp.; trade name: ADT-250, ADT-850), and mixtures thereof (for example, manufactured by NOF Corp., trade name: ADET-1800 and ADPT-4000).

In the (meth) acrylic adhesive resin (b) according to the present embodiment, when the total of all the monomer units in the (meth) acrylic adhesive resin (b) is 100% by mass, the content of the monomer unit (b3) is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

Examples of the polymerizable surfactant include a surfactant in which a polymerizable 1-propenyl group is introduced into a benzene ring of polyoxyethylene nonylphenyl ether (manufactured by Daiichi Kogyo Seiyaku Co., Ltd.; trade name: Aqualon RN-10, RN-20, RN-30, and RN-50), a surfactant in which a polymerizable 1-propenyl group is introduced into a benzene ring of ammonium salt of sulfuric acid ester of polyoxyethylene nonylphenyl ether (manufactured by Daiichi Kogyo Seiyaku Co., Ltd.; trade name: Aqualon HS-10, HS-20, and HS-1025), and a sulfosuccinate diester-based surfactant having a polymerizable double bond in the molecule (manufactured by Kao Corp.; trade name: Latemul S-120A, and S-180A).

In the (meth) acrylic adhesive resin (b) according to the present embodiment, when the total of all the monomer units in the (meth) acrylic adhesive resin (b) is 100% by mass, the content of the polymerizable surfactant is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

The (meth)acrylic adhesive resin (b) according to the present embodiment may further contain, as necessary, a monomer unit formed of a monomer having a polymerizable double bond such as vinyl acetate, acrylonitrile, or styrene.

Examples of the polymerization reaction mechanism of the (meth) acrylic adhesive resin (b) according to the present embodiment include radical polymerization, anionic polymerization, and cationic polymerization. In consideration of the manufacturing cost of the (meth)acrylic adhesive resin (b), the influence of the functional group of the monomer, and the influence of ions on the surface of the electronic component, it is preferable to carry out the polymerization by radical polymerization.

When polymerizing by a radical polymerization reaction, examples of radical polymerization initiators include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butylperoxyphthalate, t-butylperoxybenzoate, di-t-butylperoxyacetate, t-butylperoxyisobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide, and di-t-amyl peroxide; inorganic peroxides such as ammonium persulfate, potassium persulfate, and sodium persulfate; and azo compounds such as 2,2'-azobisisobutyronitrile, 2,2'-azobis-2-methylbutyronitrile, and 4,4'-azobis-4-cyanovaleric acid.

In a case of polymerizing by an emulsion polymerization method, among these radical polymerization initiators, inorganic peroxides such as water-soluble ammonium persulfate, potassium persulfate, and sodium persulfate, and, similarly, azo compounds having a carboxyl group in the molecule such as water-soluble 4,4'-azobis-4-cyanovaleric acid are preferable. Considering the influence of ions on the surface of the electronic components, ammonium persulfate and azo compounds having a carboxyl group in the molecule such as 4,4'-azobis-4-cyanovaleric acid are more preferable, and azo compounds having a carboxyl group in the molecule such as 4,4'-azobis-4-cyanovaleric acid are particularly preferable.

From the viewpoint of more stable peeling from the support substrate, the adhesive resin layer (B) according to the present embodiment preferably further includes a cross-linking agent (B2) having two or more cross-linkable functional groups in a molecule in addition to the adhesive resin (B1).

A cross-linking agent (B2) having two or more cross-linkable functional groups in one molecule is used to adjust the adhesive force and aggregating force by reacting with the functional group of the adhesive resin (B1).

Examples of the cross-linking agent (B2) include epoxy-based compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcin diglycidyl ether; isocyanate-based compounds such as tetramethylene diisocyanate, hexamethylene diisocyanate, toluene diisocyanate 3 adducts of trimethylolpropane, polyisocyanate, diphenylmethane diisocyanate, and tolylene diisocyanate; aziridine-based compounds such as trimethylolpropane-tri-β-aziridinylpropionate, tetramethylolmethane-tri-β-aziridinylpropionate, N,N'-diphenylmethane-4,4'-bis(1-aziridinecarboxamide), N,N'-hexamethylene-1,6-bis(1-aziridinecarboxamide), N,N'-toluene-2,4-bis(1-aziridinecarboxamide), and trimethylolpropane-tri-β-(2-methylaziridine) propionate; tetrafunctional epoxy-based compounds such as N,N,N',N'-tetraglycidyl-m-xylenediamine and 1,3-bis(N,N'-diglycidylaminomethyl) cyclohexane; and melamine-based compounds such as hexamethoxymethylolmelamine. These may be used alone or in a combination of two or more types.

Among the above, it is preferable to include one type or two or more types selected from epoxy-based compounds, isocyanate-based compounds, and aziridine-based compounds.

The content of the cross-linking agent (B2) is usually preferably in an approximate range in which the number of functional groups in the cross-linking agent (B2) does not exceed the number of functional groups in the adhesive resin (B1). However, in a case where a functional group is newly generated in the cross-linking reaction, or a case where the cross-linking reaction is slow, the content thereof may be greater as necessary.

From the viewpoint of more stable peeling from the support substrate, the content of the cross-linking agent (B2) in the adhesive resin layer (B) is preferably 0.5 parts by mass or more and 4.0 parts by mass or less with respect to 100 parts by mass of the adhesive resin (B1), and more preferably 1.0 part by mass or more and 3.0 parts by mass or less.

When the entire adhesive resin layer (B) is 100% by mass, the total content of the adhesive resin (B1) and the cross-linking agent (B2) in the adhesive resin layer (B) is preferably 50% by mass or more and 100% by mass or less, more preferably 70% by mass or more and 100% by mass or less, even more preferably 90% by mass or more and 100% by mass or less, and particularly preferably 95% by mass or more and 100% by mass or less. Due to this, it is possible to further suppress position shifting of electronic components in the sealing step.

When the total of the adhesive resin layer (B) is 100% by mass, the total content of at least one type selected from the adhesive resin (B1), the cross-linking agent (B2), and the gas generating component and the heat-expandable microspheres in the adhesive resin layer (B) is preferably 50% by mass or more and 100% by mass or less, more preferably 70% by mass or more and 100% by mass or less, even more preferably 90% by mass or more and 100% by mass or less, and particularly preferably 95% by mass or more and 100% by mass or less.

In addition, from the viewpoint of stably holding the electronic component on the adhesive resin layer (A) when heating or radiation as an external stimulus is applied so as to decrease the adhesive force of the adhesive resin layer (B) and peel the support substrate from the adhesive resin layer (B), in the adhesive film 50 according to the present embodiment, when the total of the adhesive resin layer (A) is 100% by mass, the content of at least one type selected from the gas generating component and the heat-expandable microspheres in the adhesive resin layer (A) is preferably 0.1% by mass or less, more preferably 0.05% by mass or less, even more preferably 0.01% by mass or less, and particularly preferably such that at least one type selected from a gas generating component and heat-expandable microspheres is not included in the adhesive resin layer (A).

From the viewpoint of improving the adhesion to the support substrate, the adhesive resin layer (B) according to the present embodiment preferably includes a tackifying resin in addition to the adhesive resin (B1). It is preferable for the adhesive resin layer (B) to contain a tackifying resin in order to easily adjust the adhesion with the support substrate at around room temperature. The tackifying resin preferably has a softening point of 100°C or higher. Specific examples of the tackifying resin include rosin-based resins such as rosin-based derivatives subjected to esterification; terpene-based resins such as α-pinene-based, β-pinene-based, dipentene-based, and terpene-phenol-based resins; natural rosins such as gum-based, wood-based, and tall oil-based rosins; hydrogenated, disproportionated, polymerized, maleated, petroleum resins in these natural rosins; and coumarone-indene resins.

Among the above, examples having a softening point in a range of 100 to 160°C are more preferable, and examples having a softening point in a range of 120 to 150°C are particularly preferable. When the tackifying resin having a softening point in the range described above is used, not only is the contamination and adhesive residue on the support substrate small, but it is possible to further improve the adhesion to the support substrate in a working environment. Further, when a polymerized rosin ester-based tackifying resin is used as the tackifying resin, not only is contamination and adhesive residue on the support substrate small, but the adhesion with the support substrate in an environment of 80 to 130°C also improves and, after expansion of the heat-expandable microspheres, it is possible to more easily carry out the peeling from the support substrate.

The blending ratio of the tackifying resin may be appropriately selected such that it is possible to adjust the elastic modulus of the adhesive resin layer (B) in a desired predetermined numerical range, without being particularly limited. However, from the viewpoint of the elastic modulus of the adhesive resin layer (B) and the initial peel force, the blending ratio is preferably 1 to 100 parts by mass with respect to 100 parts by mass of the adhesive resin (B1). When the blending ratio of the tackifying resin is the lower limit value described above or more with respect to 100 parts by mass of the adhesive resin (B1), the adhesion with the support substrate during work tends to be good. On the other hand, when the blending ratio is the upper limit value described above or less, the sticking property to the support substrate at room temperature tends to be good. From the viewpoint of adhesion to the support substrate and sticking property at room temperature, the blending ratio of the tackifying resin is more preferably 2 to 50 parts by mass with respect to 100 parts by mass of the adhesive resin (B1). In addition, the acid value of the tackifying resin is preferably 30 or less. If the acid value of the tackifying resin is the upper limit value described above or less, adhesive residue tends to be less likely to occur on the support substrate during peeling.

The thickness of the adhesive resin layer (B) is not particularly limited, but, for example, is preferably 5 µm or more and 300 µm or less, and more preferably 20 µm or more and 150 µm or less.

It is possible to form the adhesive resin layer (B), for example, by coating an adhesive on the base material layer 10. The adhesive may be dissolved in a solvent and coated as a coating solution, may be coated as an aqueous emulsion, or a liquid adhesive may be directly coated.

Among these, an adhesive coating solution dissolved in an organic solvent is preferable. The organic solvent is not particularly limited and may be appropriately selected from known organic solvents in consideration of solubility and drying time. Examples of the organic solvent include ester-based solvents such as ethyl acetate and methyl acetate; ketone-based solvents such as acetone and MEK; aromatic-based solvents such as benzene, toluene, and ethyl benzene; linear or cyclic aliphatic-based solvents such as heptane, hexane, and cyclohexane; and alcohol-based solvents such as isopropanol and butanol. Ethyl acetate and toluene are preferable as the organic solvent. These solvents may be used alone as one type or in a combination of two or more types.

As a method for coating the adhesive coating solution, it is possible to adopt a coating method known in the related art, for example, a roll coater method, a reverse roll coater method, a gravure roll method, a bar coating method, a comma coater method, or a die coater method. From the viewpoint of reducing the thermal stress of the adhesive resin layer (B) and the base material layer 10 and reducing the shrinkage rate of the adhesive film 50, the drying conditions of the coated adhesive are preferably drying for 10 seconds to 5 minutes in the temperature range of 100 to 240°C. More preferably, drying is performed in a temperature range of 120 to 200°C for 30 seconds to 3 minutes. Here, in a case where the adhesive resin layer (B) includes at least one selected from a gas generating component and heat-expandable microspheres, the drying temperature of the coated adhesive is preferably in a range which does not exceed the temperature at which the gas is generated or the temperature at which the heat-expandable microspheres expand due to heat.

### <Other Layers>

The adhesive film 50 according to the present embodiment may be further provided with, for example, an uneven absorption layer, a shock absorption layer, or an easy-adhesion layer, between the base material layer 10 and the adhesive resin layer (A) or between the base material layer 10 and the adhesive resin layer (B) as long as the effect of the present embodiment is not impaired.

The uneven absorption layer is preferably formed of a natural rubber, a synthetic rubber, or a synthetic resin having rubber elasticity having a Shore D type hardness according to D type Shore of ASTM D-2240 of, for example, 50 or less, preferably 40 or less. The thickness of the uneven absorption layer is, for example, 500 µm or less, preferably 5 to 300 µm, and more preferably 10 to 150 µm.

Examples of the synthetic rubber and synthetic resin include nitrile-based, diene-based, and acrylic-based synthetic rubbers, polyolefin-based and polyester-based thermoplastic elastomers, synthetic resins having elasticity such as ethylene/vinyl acetate copolymers, polyurethane, polybutadiene, and soft polyvinyl chloride. Here, in the present embodiment, even with an essentially hard polymer such as polyvinyl chloride, it is also possible to use an example which has rubber elasticity in combination with a compounding agent such as a plasticizer or a softener. In addition, it is possible to preferably use the adhesive resins exemplified in the adhesive resin layer (A) and adhesive resin layer (B) described above for forming the uneven absorption layer.

### 2. Electronic Device Manufacturing Method

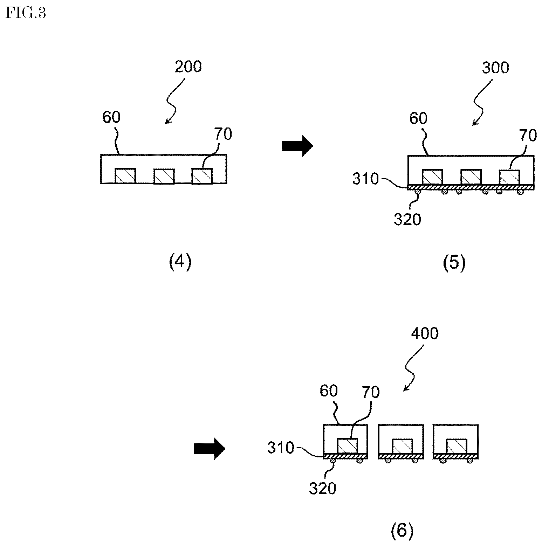

Next, a description will be given of a method for manufacturing the electronic device according to the present embodiment. Figs. 2 and 3 are cross-sectional views schematically showing an example of a method for manufacturing an electronic device of an embodiment according to the present invention.

The electronic device manufacturing method according to the present embodiment is provided with at least the following four steps.
(1) A step of preparing a structure 100 provided with the adhesive film 50, an electronic component 70 attached to the adhesive resin layer (A) of the adhesive film 50, and the support substrate 80 attached to an adhesive resin layer (B) of the adhesive film 50
(2) A step of sealing the electronic component 70 with a sealing material 60
(3) A step of peeling the support substrate 80 from the structure 100 by decreasing the adhesive force of the adhesive resin layer (B) by applying an external stimulus
(4) A step of peeling the adhesive film 50 from the electronic component 70

Then, in the method for manufacturing the electronic device according to the present embodiment, the adhesive film 50 according to the present embodiment described above is used as the adhesive film for temporarily fixing the electronic component 70.

A description will be given below of each step of the method for manufacturing an electronic device according to the present embodiment.

### (Step (1))

First, the structure 100 is prepared, which is provided with the adhesive film 50, the electronic component 70 attached to the adhesive resin layer (A) of the adhesive film 50, and the support substrate 80 attached to the adhesive resin layer (B) of the adhesive film 50.

It is possible to manufacture the structure 100, for example, by the following procedure.

First, the adhesive film 50 is attached onto the support substrate 80 such that the adhesive resin layer (B) is on the support substrate 80 side. A protective film may be attached on the adhesive resin layer (B), and it is possible to peel off the protective film and to attach the exposed surface of the adhesive resin layer (B) to the surface of the support substrate 80.

As the support substrate 80, for example, it is possible to use a quartz substrate, a glass substrate, or a SUS substrate.

Next, it is possible to obtain the structure 100 by arranging the electronic component 70 on the adhesive resin layer (A) of the adhesive film 50 attached on the support substrate 80.

Examples of the electronic component 70 include a semiconductor chip such as an IC, an LSI, a discrete component, a light emitting diode, or a light receiving element, a semiconductor panel, or a semiconductor package.

### (Step (2))

Next, the electronic component 70 is sealed with the sealing material 60.

The electronic component 70 is covered with the sealing material 60, and the electronic component 70 is sealed by curing the sealing material 60 at a temperature of 180°C or lower, for example. Here, in a case where the adhesive resin layer (B) of the adhesive film 50 includes at least one selected from a gas generating component and heat-expandable microspheres, the temperature at which the sealing material 60 is cured is preferably in a range which does not exceed the temperature at which the gas is generated or the temperature at which the heat-expandable microspheres expand due to heat.

In addition, the form of the sealing material 60 is not particularly limited, but is, for example, a granular form, a sheet form, or a liquid form.

The sealing material 60 is not particularly limited, but, for example, it is possible to use an epoxy resin-based sealing material using an epoxy resin.

In particular, a liquid epoxy resin-based sealing material is preferable from the viewpoint of improving the affinity of the sealing material 60 with the adhesive film 50 and being able to more evenly seal the electronic component 70. As such an epoxy resin-based sealing material, for example, it is possible to use the T693/R4000 series, T693/R1000 series, and T693/R5000 series manufactured by Nagase Chemtex Corp.

Examples of the sealing method include transfer molding, injection molding, compression molding, and cast molding. After sealing the electronic component 70 with the sealing material 60, for example, the sealing material 60 is cured by heating at a temperature of 180°C or lower and the structure 100 in which the electronic component 70 is sealed is obtained.

### (Step (3))

Next, the adhesive force of the adhesive resin layer (B) is decreased by applying an external stimulus and the support substrate 80 is peeled from the structure 100.

It is possible to easily remove the support substrate 80 from the adhesive film 50 by, for example, sealing the electronic component 70 and then heating at a temperature over 180°C to decrease the adhesive force of the adhesive resin layer (B).

### (Step (4))

Next, the adhesive film 50 is removed from the electronic component 70 to obtain an electronic device 200.

Examples of a method for removing the adhesive film 50 from the electronic component 70 include a mechanical peeling method, a method for decreasing the adhesive force of the surface of the adhesive film 50 and then peeling the adhesive film 50.

### (Step (5))

As shown in Fig. 3, the method for manufacturing an electronic device according to the present embodiment may be further provided with a step (5) of forming a wiring layer 310 and a bump 320 on an exposed surface of the obtained electronic device 200 to obtain an electronic device 300.

The wiring layer 310 is provided with a pad (not shown) which is an external connection terminal formed on the outermost surface, and wiring (not shown) which electrically connects the exposed electronic component 70 and the pad. It is possible to form the wiring layer 310 by a method known in the related art and the structure thereof may be multi-layer.

Then, it is possible to obtain the electronic device 300 by forming the bump 320 on the pad of the wiring layer 310. Examples of the bump 320 include a solder bump, and a gold bump. It is possible to form the solder bump, for example, by arranging a solder ball on a pad which is an external connection terminal of the wiring layer 310 and carrying out heating to melt (reflow) the solder.

It is possible to form the gold bump by methods such as a ball bonding method, a plating method, or an Au ball transfer method.

### (Step (6))

The method for manufacturing an electronic device according to the present embodiment may be further provided with a step (6) of dicing the electronic device 300 to obtain a plurality of electronic devices 400, as shown in Fig. 3.

It is possible to perform the dicing of the electronic device 300 by a known method.

A description was given above of the embodiments of the present invention, but these are Examples of the present invention and it is also possible to adopt various configurations other than the above.

### [Examples]

A specific description will be given below of the present invention with reference to Examples, but the present invention is not limited thereto.

Details of the materials used to manufacture the adhesive film are as follows.

### <Adhesive Resin Solution SA1>

Into deionized pure water, 0.5 parts by mass of 4,4'-azobis-4-cyanovaleric acid (manufactured by Otsuka Chemical Co., Ltd.; trade name: ACVA) as a polymerization initiator, 78 parts by mass of n-butyl acrylate and 10 parts by mass of methyl methacrylate as the monomer (a1), 9 parts by mass of -2-hydroxyethyl methacrylate as the monomer (a2), and 3 parts by mass of a polymerizable surfactant in which a polymerizable 1-propenyl group was introduced into a benzene ring of ammonium salt of sulfuric acid ester of polyoxyethylene nonylphenyl ether (manufactured by Daiichi Kogyo Seiyaku Co., Ltd.; trade name: Aqualon HS-1025) were each added, and emulsion polymerization was carried out for 8 hours at 70 to 72°C while stirring to obtain an acrylic-based resin emulsion. The result was neutralized with aqueous ammonia (pH = 7.0) to obtain an adhesive resin solution SA1 having a solid content concentration of 42.5%.

### <Adhesive Resin Solution SA2>

Into deionized pure water, 0.5 parts by mass of ammonium persulfate as a polymerization initiator, 61 parts by mass of 2-ethylhexyl acrylate, 20 parts by mass of acrylic acid-n-butyl, and 9 parts by mass of methyl methacrylate as the monomer (a1), 3 parts by mass of 2-hydroxyethyl methacrylate as the monomer (a2), 1 part by mass of polytetramethylene glycol diacrylate (manufactured by NOF Corp.; trade name; ADT-250) as a monomer (a3), and 2 parts by mass of a polymerizable surfactant in which a polymerizable 1-propenyl group was introduced into a benzene ring of an ammonium salt of a sulfuric acid ester of polyoxyethylene nonylphenyl ether (manufactured by Daiichi Kogyo Seiyaku Co., Ltd.; trade name: Aqualon HS-1025) were each added, and emulsion polymerization was carried out for 8 hours at 70 to 72°C while stirring to obtain an acrylic-based resin emulsion. The result was neutralized with aqueous ammonia (pH = 7.0) to obtain an adhesive resin solution SA2 having a solid content concentration of 56.5%.

### <Adhesive Coating Solution A1>

55 parts by mass of adhesive resin solution SA1, 45 parts by mass of adhesive resin solution SA2, 0.5 parts by mass of dimethylethanolamine, and 4 parts by mass of an epoxy-based compound (Ex-1610, manufactured by Nagase Chemtex Corp.) as a cross-linking agent were mixed together to obtain an adhesive coating solution A1.

### <Adhesive Resin Solution SB1>

In a mixed solvent including ethyl acetate and toluene, 0.5 parts by mass of t-butylperoxy-2-ethylhexanoate (manufactured by NOF Corp.; trade name: Perbutyl O (registered trademark)) as a polymerization initiator, 35 parts by weight of 2-ethylhexyl acrylate, 40 parts by mass of acrylic acid-n-butyl, and 15 parts by mass of ethyl acrylate as monomer (b1), 10 parts by mass of 2-hydroxyethyl methacrylate as monomer (b2) were each added and solution polymerization was carried out at 83 to 87°C for 11 hours while stirring to obtain an acrylic-based resin solution having a solid content concentration of 45% by mass. The result was set as the adhesive resin solution SB1.

### <Adhesive Coating Solution B1>

100 parts by mass of the adhesive resin solution SB1 and 0.9 parts by mass (2 parts by mass with respect to 100 parts by mass of the adhesive resin) of an isocyanate-based cross-linking agent (manufactured by Mitsui Chemicals, Inc.; trade name: Olester P49-75S) were each mixed and the solid content concentration was adjusted to 40% with ethyl acetate to obtain an adhesive coating solution B1.

### <Adhesive Coating Solution B2>

100 parts by mass of the adhesive resin solution SB1, 2.25 parts by weight of a polymerized rosin ester-based tackifier (manufactured by Arakawa Chemical Industries, Ltd.; trade name: Pensel D-125) (5 parts by mass with respect to 100 parts by mass of adhesive resin), 1.2 parts by mass of an isocyanate-based cross-linking agent (manufactured by Mitsui Chemicals, Inc.; trade name: Olester P49-75S) (2 parts by mass with respect to 100 parts by mass of adhesive resin), 6.75 parts by mass of heat-expandable microspheres (Sekisui Chemical Co., Ltd.; trade name: Advancell EM-503) (15 parts by mass with respect to 100 parts by mass of the adhesive resin) were each mixed and the solid content concentration was adjusted to 30% with ethyl acetate to prepare an adhesive coating solution B2.

### [Example 1]

On the polyethylene terephthalate (PET) film 1 which is a base material layer (uniaxially stretched film, thickness: 38 µm, shrinkage rate in MD direction: 1.2%, shrinkage rate in TD direction 0.3% (here, the MD direction is the direction of maximum heat shrinkage), an adhesive coating solution A1 was coated and then dried by heating at 120°C for 1 minute to form an adhesive resin layer (A) having a thickness of 10 µm. Next, an adhesive coating solution B1 was coated onto the separator and dried by heating at 120°C for 1 minute to form an uneven absorption layer having a thickness of 20 µm. Next, the uneven absorption layer having a thickness of 20 µm was formed on the surface of the PET film 1 opposite to the adhesive resin layer (A) via a separator and the adhesive coating solution B2 was coated thereon and dried by heating at 120°C for 1 minute to form an adhesive resin layer (B) having a thickness of 25 µm, and an adhesive film having the adhesive resin layer (B) was obtained.

Here, the PET film 1 was subjected to a stress relaxation treatment by a heat treatment.

The following evaluation was performed on the obtained adhesive film. The obtained results are shown in Table 1.

### [Comparative Example 1]

An adhesive film was obtained in the same manner as in Example 1 except that, as a base material layer, instead of the PET film 1, a PET film 2 (uniaxially stretched film, thickness: 38 um, shrinkage rate in MD direction: 1.4%, shrinkage rate in TD direction 0.3% (here, the MD direction is the direction of maximum heat shrinkage) was used.

Here, the PET film 2 was not subjected to a stress relaxation treatment by a heat treatment.

The following evaluation was performed on the obtained adhesive film. The obtained results are shown in Table 1.

### <Evaluation>

### (1) Measurement of Shrinkage Rate of Adhesive Film and Base Material Layer

The shrinkage rate of the adhesive film and the base material layer was measured under conditions of heating at 150°C for 30 minutes in accordance with JIS C2151.

More specifically, the measurement was as follows.
Measuring device: TMA-7000 manufactured by Hitachi High-Tech Science Corporation
Sample width: 4 mm
Sample length: 20 mm
Tensile load: 5 g

For the heating and cooling of the sample, the sample was heated by putting the sample in a movable furnace set at 150°C and the sample was cooled by taking the sample out from the furnace.

### (2) Presence or Absence of Floating of Adhesive Film during Prebaking

The adhesive resin layer (B) side of the 10 cm × 10 cm adhesive film obtained in Examples and Comparative Examples was subjected to pressure adhesion at a pressure of 0.5 MPa on a mirror-treated stainless steel sheet (SUS304BA plate) having a length of 10 cm, a width of 10 cm, and a thickness of 1 mm. Next, two slide glasses (manufactured by Muto Pure Chemicals Co., Ltd., product name: slide glass 1102) having a length of 76 mm, a width of 26 mm, and a thickness of 1.0 mm were placed at 5 mm intervals in the center of the adhesive resin layer (A) of the adhesive film and brought into close contact to obtain a structure.

Next, the obtained structure was subjected to a prebaking treatment at 130°C for 30 minutes. Next, the structure was cooled to room temperature, and the presence or absence of floating of the adhesive film from the stainless steel sheet was examined and evaluated according to the following criteria.

No floating: No floating of the adhesive film from the stainless steel sheet was visually observed.

Floating: Floating of the adhesive film from the stainless steel sheet was visually observed.

### (3) Position Shifting of Electronic Components in Sealing Step

The adhesive resin layer (B) side of the adhesive films obtained in Examples and Comparative Examples was bonded onto a stainless steel sheet (ϕ310 mm, thickness 1.5 mm) for compression molding and semiconductor chips with a size of 5.0 mm square as electronic components were mounted and adhered on the adhesive resin layer (A) of the adhesive film so as to be in a grid pattern with an interval of 2.0 mm to obtain a structure.

Next, using a compression molding machine, a plurality of semiconductor chips on the adhesive resin layer (A) were sealed by compression molding with a liquid epoxy resin-based sealing material (manufactured by Nagase Chemtex Corp., trade name: T693/R4212-2C) to obtain a structure in which a sealing resin wafer (ϕ300 mm, thickness 0.5 mm) was formed on a stainless steel sheet.

Next, the position shifting of electronic components was evaluated based on the following criteria.

No shifting: no position shifting of the semiconductor chip was visually observed

Shifting: position shifting was visually observed in at least part of the semiconductor chip

### (4) Heat Peelability after Sealing Step

The adhesive resin layer (B) side of the 10 cm × 10 cm adhesive film obtained in the Examples and Comparative Examples was subjected to pressure adhesion at a pressure of 5 MPa on a mirror-finished stainless steel sheet (SUS304BA sheet) having a length of 10 cm × width of 10 cm × thickness of 1 mm. Next, the obtained structure was subjected to a heat treatment at 130°C for 30 minutes to stabilize the adhesive force of the adhesive resin layer (A) and the adhesive resin layer (B). Next, the structure was cooled to room temperature.

Next, after heating the structure on a hot plate at 190°C for 2 minutes, the adhesive film was peeled from the stainless steel sheet under conditions of 23°C and a tensile speed of 300 mm/min, and the 180° peel force was measured.

The possibility of heat peeling the adhesive film from the stainless steel sheet was evaluated based on the following criteria.
Possible: 180° peel force of less than 0.5 N/25 mm
Not possible: 180° peel force of 0.5N/25 mm or more

### [Table 1]

**[Table 1]**

| | Shrinkage rate when heat treated at 150°C for 30 min (%) | | Floating during prebaking | Position shifting of electronic components | Presence or absence of peeling |
|---|---|---|---|---|---|
| | MD direction (direction of maximum heat shrinkage) | TD direction | | | |
| Example 1 | 0.00 | 0.00 | No | No | Present |
| Comparative Example 1 | 0.48 | 0.03 | Yes | Yes | Present |

In the Examples using an adhesive film having a shrinkage rate in the range of 0.0% or more and 0.40% or less, floating from the support substrate was not observed at the time of prebaking and position shifting of the semiconductor element in the sealing step was not observed. Thus, it is understood that the adhesive films of Examples were able to suppress position shifting of electronic components in the sealing step.

On the other hand, in Comparative Examples using an adhesive film having a shrinkage rate in a range of more than 0.40%, the position shifting of the semiconductor element was observed in the sealing step. Thus, in the adhesive film of the Comparative Examples, it is understood that position shifting of the electronic component was generated in the sealing step.

This application claims priority based on Japanese Patent Application 2018-190041 filed on October 5, 2018.

### REFERENCE SIGNS LIST

A: Adhesive resin layer
B: Adhesive resin layer
10: Base material layer
10A: First surface
10B: Second surface
50: Adhesive film
60: Sealing material
70: Electronic component
80: Support substrate
100: Structure
200: Electronic device
300: Electronic device
310: Wiring layer
320: Bump
400: Electronic device

## Claims

1. Use of an adhesive film for temporarily fixing an electronic component when the electronic component is sealed with a sealing material in an electronic device manufacturing process,
the adhesive film comprising:
a base material layer;
an adhesive resin layer (A) which is provided on a first surface side of the base material layer; and
an adhesive resin layer (B) which is provided on a second surface side of the base material layer and of which an adhesive force is decreased by heating or radiation as an external stimulus,
wherein a shrinkage rate of the film in a direction that the heat shrinkage of the adhesive film is maximum is 0.0% or more and 0.40% or less as measured under conditions of heating at 150°C for 30 minutes in accordance with JIS C2151,
the base material layer includes a uniaxially stretched or biaxially stretched polyester film and
the adhesive resin layer (A) includes a (meth)acrylic adhesive resin.

2. The use according to claim 1,
wherein an adhesive force of the adhesive resin layer (B) is decreased by heating at a temperature over 180°C.

3. The use according to claim 2,
wherein the adhesive resin layer (B) includes at least one selected from a gas generating component and heat-expandable microspheres.

4. The use according to any one of claims 1 to 3,
wherein a content of the at least one selected from a gas generating component and heat-expandable microspheres in the adhesive resin layer (A) is 0.1% by mass or less when the entire adhesive resin layer (A) is set to 100% by mass.

5. A method for manufacturing an electronic device comprising at least:
a step (1) of preparing a structure having the adhesive film as defined in any one of claims 1 to 4, an electronic component attached to the adhesive resin layer (A) of the adhesive film, and a support substrate attached to the adhesive resin layer (B) of the adhesive film;
a step (2) of sealing the electronic component with a sealing material;
a step (3) of peeling the support substrate from the structure by decreasing an adhesive force of the adhesive resin layer (B) by applying an external stimulus; and
a step (4) of peeling the adhesive film from the electronic component.

6. The method for manufacturing an electronic device according to claim 5,
wherein the sealing material is an epoxy resin-based sealing material.

## Patentansprüche

1. Verwendung eines Klebefilms zum vorübergehenden Fixieren eines elektronischen Bauteils, wenn das elektronische Bauteil in einem Herstellungsverfahren für eine elektronische Vorrichtung mit einem Dichtungsmaterial versiegelt wird,
wobei der Klebefilm folgendes umfasst:
eine Basismaterialschicht;
eine Klebeharzschicht (A), die auf einer ersten Oberflächenseite der Basismaterialschicht vorgesehen ist; und
eine Klebeharzschicht (B), die auf einer zweiten Oberflächenseite der Basismaterialschicht vorgesehen ist und deren Klebekraft durch Erwärmen oder Strahlung als äußerem Stimulus verringert wird,
wobei eine Schrumpfungsrate des Films in einer Richtung, in der die Wärmeschrumpfung des Klebefilms maximal ist, 0,0 % oder mehr und 0,40 % oder weniger beträgt, gemessen unter Bedingungen des Erwärmens bei 150°C für 30 Minuten gemäß JIS C2151,
die Basismaterialschicht eine uniaxial gestreckte oder biaxial gestreckte Polyesterfolie einschließt und
die Klebeharzschicht (A) ein (Meth)acrylklebeharz einschließt.

2. Verwendung gemäß Anspruch 1,
wobei die Klebekraft der Klebeharzschicht (B) durch Erwärmen auf eine Temperatur über 180°C verringert wird.

3. Verwendung gemäß Anspruch 2,
wobei die Klebeharzschicht (B) mindestens eine Komponente einschließt, ausgewählt aus einer gaserzeugenden Komponente und wärmeausdehnbaren Mikrokugeln.

4. Verwendung gemäß mindestens einem der Ansprüche 1 bis 3,
wobei ein Gehalt des mindestens einen Bestandteils, ausgewählt aus einer gaserzeugenden Komponente und wärmeausdehnbaren Mikrokugeln, in der Klebeharzschicht (A) 0,1 Massen-% oder weniger beträgt, wenn die gesamte Klebeharzschicht (A) auf 100 Massen-% eingestellt ist.

5. Verfahren zur Herstellung einer elektronischen Vorrichtung, umfassend mindestens:
einen Schritt (1) des Herstellens einer Struktur, die den in mindestens einem der Ansprüche 1 bis 4 definierten Klebefilm, ein an der Klebeharzschicht (A) des Klebefilms angebrachtes elektronisches Bauteil, und ein an der Klebeharzschicht (B) des Klebefilms angebrachtes Trägersubstrat aufweist;
einen Schritt (2) des Versiegelns des elektronischen Bauteils mit einem Dichtungsmaterial;
einen Schritt (3) des Ablösens des Trägersubstrats von der Struktur durch Verringern einer Klebkraft der Klebeharzschicht (B) durch Anlegen eines äußeren Stimulus; und
einen Schritt (4) des Ablösens des Klebefilms von dem elektronischen Bauteil.

6. Verfahren zur Herstellung einer elektronischen Vorrichtung gemäß Anspruch 5,
bei dem das Dichtungsmaterial ein Dichtungsmaterial auf Epoxidharzbasis ist.

## Revendications

1. Utilisation d'un film adhésif destiné à fixer temporairement un composant électronique lorsque le composant électronique est scellé avec un matériau de scellement dans un processus de fabrication de dispositif électronique, le film adhésif comprenant :
une couche de matériau de base ;
une couche de résine adhésive (A) qui est fournie sur un premier côté de surface de la couche de matériau de base ; et
une couche de résine adhésive (B) qui est fournie sur un second côté de surface de la couche de matériau de base et dont une force adhésive est diminuée par chauffage ou rayonnement en tant que stimulus externe,
dans laquelle un taux de rétrécissement du film dans une direction selon laquelle le rétrécissement thermique du film adhésif est au maximum est de 0,0 % ou plus et de 0,40 % ou moins, tel que mesuré dans des conditions de chauffage à 150 °C pendant 30 minutes conformément à JIS C2151,
la couche de matériau de base inclut un film polyester étiré uniaxialement ou étiré biaxialement, et
la couche de résine adhésive (A) inclut une résine adhésive (méth)acrylique.

2. Utilisation selon la revendication 1,
dans laquelle une force adhésive de la couche de résine adhésive (B) est diminuée par chauffage à une température supérieure à 180 °C.

3. Utilisation selon la revendication 2,
dans laquelle la couche de résine adhésive (B) inclut au moins l'un sélectionné parmi un composant générateur de gaz et des microsphères thermiquement expansibles.

4. Utilisation selon l'une quelconque des revendications 1 à 3,
dans laquelle une teneur en l'au moins un sélectionné à partir d'un composant générateur de gaz et des microsphères thermiquement expansibles dans la couche de résine adhésive (A) est de 0,1 % en masse ou moins lorsque l'intégralité de la couche de résine adhésive (A) est établie à 100 % en masse.

5. Procédé de fabrication d'un dispositif électronique comprenant au moins :
une étape (1) consistant à préparer une structure présentant le film adhésif comme défini dans l'une quelconque des revendications 1 à 4, un composant électronique fixé à la couche de résine adhésive (A) du film adhésif et un substrat de support fixé à la couche de résine adhésive (B) du film adhésif ;
une étape (2) consistant à sceller le composant électronique avec un matériau de scellement ;
une étape (3) consistant à décoller le substrat de support de la structure en diminuant une force adhésive de la couche de résine adhésive (B) en appliquant un stimulus externe ; et
une étape (4) consistant à décoller le film adhésif du composant électronique.

6. Procédé destiné à fabriquer un dispositif électronique selon la revendication 5,
dans lequel le matériau de scellement est un matériau de scellement à base de résine époxyde.
